Europäisches Patentamt

European Patent Office

Office européen des brevets

(11) Publication number: **0 490 288 A2**

# EUROPEAN PATENT APPLICATION

(21) Application number: **91120962.5**

(22) Date of filing: **06.12.91**

(51) Int. Cl.5: **H01L 21/3205**, H01L 29/92, H01G 7/02

(30) Priority: **11.12.90 US 625555**

(43) Date of publication of application:
**17.06.92 Bulletin 92/25**

(84) Designated Contracting States:
**DE FR GB IT NL**

(71) Applicant: **RAMTRON CORPORATION**
**1850 Ramtron Drive**
**Colorado Springs Colorado 80918(US)**

(72) Inventor: **Schuele, Paul J.**
**4385 Pebble Ridge No. 201**
**Colorado Springs, Colorado 80906(US)**
Inventor: **Kammerdiner, Lee**
**39327 Harbour Road**
**Avondale, Colorado 81022(US)**
Inventor: **Larson, William**
**635 Hempstead Place**
**Colorado Springs, Colorado 80906(US)**
Inventor: **Traynor, Steven D.**
**3125 Deliverence Drive**
**Colorado Springs, Colorado 80918(US)**

(74) Representative: **Buzzi, Franco et al**
**c/o Jacobacci-Casetta & Perani S.p.A. Via
Alfieri, 17**
**I-10121 Torino(IT)**

(54) **Process for fabricating PZT capacitors as integrated circuit memory elements and a capacitor storage element.**

(57) A method of forming a planar storage capacitor element having a noble metal or noble metal alloy top electrode (22), a layer of lead zirconate titanate (22), and a noble metal or noble metal alloy bottom electrode (16, 18).

FIG.3

The present invention is directed to a method for forming a high quality planar ferroelectric capacitor using noble metal electrodes and Pb-$(Zr_xTi_{1-x})O_3$ (also known as PZT) films. The present invention allows small ferroelectric capacitors using PZT to be fabricated for use in semiconductor circuits.

Prior data published on PZT systems, such as in R. Atkin, "Performance of Sputtered $Pb_{0.42}Bi_{0.07}$-$(Fe_{0.405}$ $Nb_{0.325}$ $Zr_{0.27})O_3$ Ferroelectric Memory Films", Ferroelectric, vol. 3, 213 (1972) and D. Chapman, "Some Thin-Film Properties of a New Ferroelectric Composition", J. Appl. Phys., vol. 40, 2381 (1969), disclose ferroelectric films utilizing gold top electrodes. Other publications such as R. Moazzami, et al., "A Ferroelectric DRAM Cell for High-Density NVRAM's IEEE Electron Device Letters, vol. 11, 454 (October, 1990) and L. Parker, et al., "Ferroelectric Materials for 64 Mb and 256 Mb DRAMs", IEEE, p. 17 (January, 1990), address a PZT system for simple test devices which are not useful for semiconductor application.

For example, capacitors have been fabricated on unpatterned PZT films leading to adhesion loss in later fabrication steps. The available published data is on very large capacitors (greater than 100 x 100 microns) which are much too large for semiconductor use. Additional published data is on capacitors with either aluminum or gold top electrodes. These materials, however, cannot be used for production devices. For example, gold diffuses into the capacitor structure during processing and may produce shorts and variations in capacitor effective thickness. In the case of aluminum, an oxide layer with a low dielectric constant is formed between the electrode and ferroelectric layer which decreases the field applied across the ferroelectric capacitor and leads to low and poorly controlled switching behavior. Further, noble metal electrodes which are not annealed perform poorly because intimate contact is not formed with the PZT layer. Thus, the fabrication of capacitors following the prior art produces variations in ferroelectric properties and fails to disclose the improved electrical performance and reliability which have been obtained in the present invention by varying PZT stoichiometry and doping.

Accordingly, a general object of the present invention is to provide a method which does not suffer from the drawbacks described above.

The present invention is directed to a planar capacitor storage element having a patterned metal interconnect overlying a dielectric isolation layer. The metal interconnect contacts a patterned noble metal or noble metal alloy top electrode through an opening etched in the dielectric layer. The patterned top electrode overlying a patterned ferroelectric film does not extend beyond the edges of the patterned ferroelectric film overlying a patterned noble metal or noble metal alloy bottom electrode. The bottom electrode overlying an isolation layer extends beyond the patterned ferroelectric film.

The present invention is further directed to a memory device and a method for forming a memory device wherein a planar capacitor storage element includes a noble metal or noble metal alloy top electrode overlying a ferroelectric film with a thickness ranging from 500 Angstroms to 1.0 microns. The ferroelectric film overlies a noble metal or noble metal alloy bottom electrode.

The present invention is still further directed to a method of forming the planar storage capacitor element of the present invention. In general, the method comprises a sequence of processing steps to produce a high quality planar ferroelectric capacitor using noble metal electrodes and PZT. The PZT film, which is represented by the formula Pb-$(Zr_xTi_{1-x})O_3$, has a stoichiometry ranging from $x = 0.0$ to $x = .92$ with a preferred range from $x = 0.46$ to $x = 0.54$. The order in which the process steps are carried out, the range of layer thicknesses, the PZT stoichiometry range and the annealing conditions when all taken together constitute an improved method for integrating a non-volatile ferroelectric capacitor circuit element in a semiconductor circuit fabrication process.

Accordingly, the present invention allows small (less than 3x3 micron) ferroelectric capacitors using PZT to be fabricated for use in semiconductor circuits. The capacitors have a switched charge (which is the property used for information storage) greater than 20 micro-C/cm$^2$ after complete semiconductor processing. Problems with Poor adhesion and highly variable ferroelectric performance which are characteristic of the Prior art capacitors are eliminated.

Figure 1 is a cross-sectional view of a portion of an integrated circuit wherein the transistor gate electrode layer 10 is isolated from overlying circuit elements (not shown) by a layer 12 of (deposited) silicon oxide glass.

Figure 2 shows the structure of Fig. 1 with a titanium adhesion layer 16 overlying the silicon oxide glass, a noble metal bottom electrode layer 18 overlying the titanium adhesion layer and a layer of the ferroelectric PZT overlying the bottom electrode.

Figure 3 shows the structure of Fig. 2 with an overlying noble metal top electrode 22 and a photoresist pattern 24 defining the area of the capacitor.

Figure 4 shows the structure of Fig. 3 after a portion of the top electrode layer 22 has been removed.

Figure 5 shows the structure of Fig. 4 with a photoresist pattern 26 overlying the previously defined top electrode.

Figure 6 shows the structure of Fig. 5 with a portion of the ferroelectric PZT layer 20 removed.

Figure 7 shows the structure of Fig. 6 with the photoresist layer removed.

Figure 8 shows the structure of Fig. 7 with a photoresist pattern 28 defining the bottom electrode.

Figure 9 shows the structure of Fig. 8 with the photoresist layer removed.

Figure 10 shows the structure of Fig. 9 with an overlying silicon oxide layer 30 through which contact openings have been cut by conventional photo patterning and etch.

Figure 11 shows the structure of Fig. 10 with an overlying layer 32 of aluminum interconnected with conventional photo patterning and etch.

The present invention in some of its aspects comprises a series of fabrication steps which are carried out in the manner set forth below.

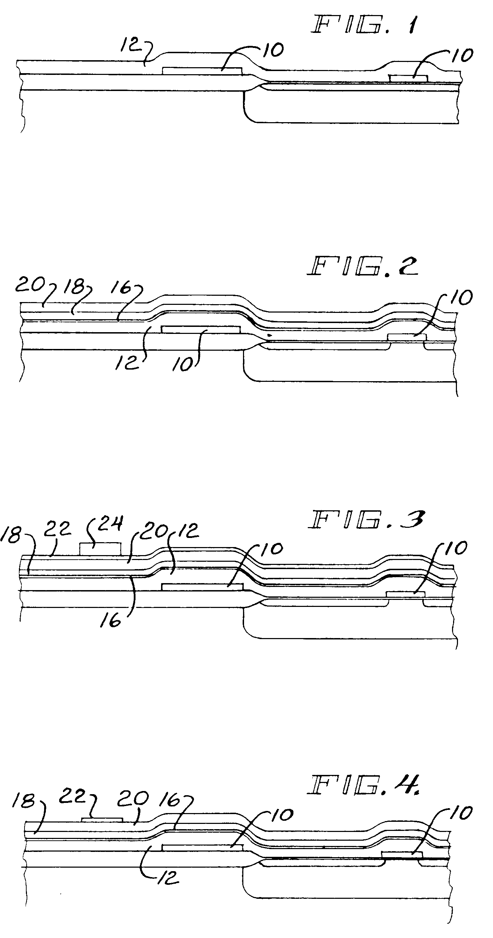

As shown in Fig. 1, transistors having gate electrodes 10 for circuit control are fabricated by conventional CMOS semiconductor processes up to the point of polysilicon definition, as is known in the art. Electrodes 10 are isolated from the overlying circuit elements by a deposited silicon oxide glass layer 12.

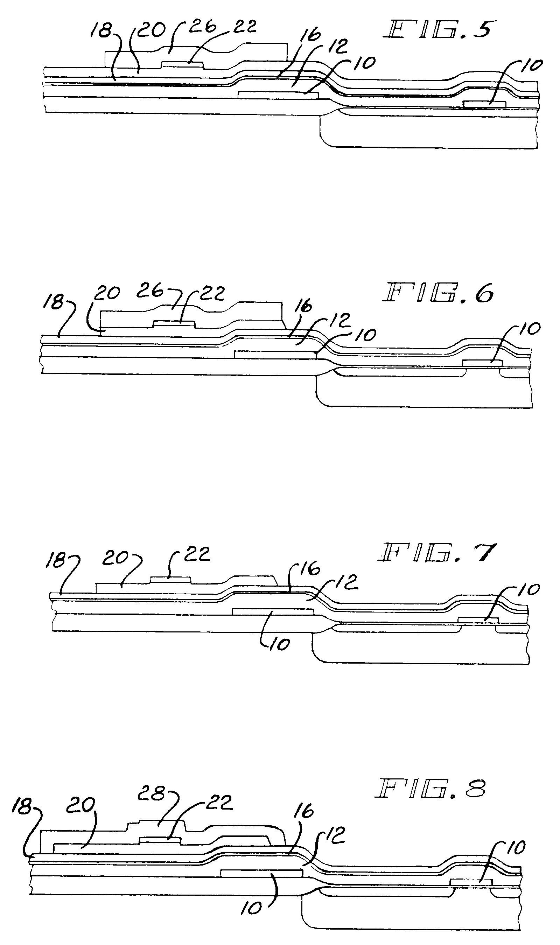

In Figure 2, in accordance with the present invention, a bottom electrode structure is deposited by sputtering. The bottom electrode structure comprises a titanium adhesion layer 16 followed by a layer of noble metal or noble metal alloy 18. The preferred thickness of titanium adhesion layer 16 is between 100 and 1500 Angstroms, and the preferred thickness of the noble metal layer 18 is between 500 and 5,000 Angstroms. The preferred range of thickness for titanium is from 200 to 500 Angstroms and from 1,000 to 2,500 Angstroms for the noble metal. Noble metal and titanium layer thicknesses outside of these ranges either do not adhere to the underlayers or do not produce satisfactory capacitors due to excessive interdiffusion between the noble metal and the titanium.

Pure noble metals such as platinum (Pt) and palladium (Pd) as well as the alloys Pt-Pd, Pt-Ti, Pd-Ti, Pt-Bi, Pd-Bi, Pt-Re, Pd-Re, Pt-Pd-Ti, Pt-Bi-Ti, Pd-Bi-Ti, Pt-Ru or Pd-Ru may also be used for the bottom electrode. The composition can effect film adhesion as well as the morphology of the overlying PZT layer. Because titanium from the adhesion layer will diffuse into the noble metal bottom electrode, the composition of the bottom electrode structure will vary from the top surface to the interface with underlying silicon oxide layer 12.

Next, as also shown in Figure 2, a layer 20 of lead zirconate titanate, called "PZT" and having the general formula $Pb(Zr_xTi_{1-x})O_3$ is deposited by sputtering from a composite oxide target, or by reactive sputtering in an ambient of $O_2$ from a composite metal target, or by spinning a layer of Sol-Gel material composed of the Pb, Zr and Ti metal-organic compounds onto the substrate. The $Pb(Zr_xTi_{1-x})O_3$ stoichiometry can be in the range from x = 0.0 to x = .92 with the range from x = 0.46 to x = 0.54 as the preferred range. This layer 20 of PZT can be between 500 Angstroms and 1.0 microns thick. The preferred PZT layer thickness range of 2,000 to 5,000 Angstroms produces adequate switched charge for 5 volt operation. Thicknesses below 2,000 Angstroms do not produce a high quality ferroelectric and thicknesses above 5,000 Angstroms (0.5 microns) may have high coercive voltages.

The PZT layer 20 is then annealed at a temperature greater than 500°C in an $O_2$ ambient using either a furnace or a rapid thermal annealing process to produce the ferroelectric perovskite phase.

In Figure 3, a top electrode layer 22 of noble metal or noble metal alloy between 100 and 4500 Angstroms thick is deposited by sputtering. The noble metals and the noble metal alloys described above in connection with the bottom electrode may also be suitable for fabrication of the top electrode. The preferred thickness of this layer is between 200 and 1500 Angstroms. Also, as shown in Figure 3, a photoresist pattern 24, established by conventional means, defines the area of the capacitor to be formed. Next, the noble metal top electrode layer 22 is removed (defined) by ion milling, plasma etching, or wet etching to leave only the desired capacitor top electrode as seen in Figure 4. The photoresist has been removed. This wafer is then annealed at a temperature above 500°C in an $O_2$ ambient using either a furnace or rapid thermal-annealing. This step is critical to produce the intimate contact between the ferroelectric and the top electrode which is essential to produce high amounts of switched charge for 5 volt operation.

As seen in Figure 5, another photoresist pattern 26 is established by conventional means and serves to define an area larger than and encompassing that of the previously defined capacitor top electrode. The exposed PZT layer 20 is removed by ion milling, plasma etching, or wet etching to leave only the material required for the capacitor as shown by the structure in Fig. 6. This step is necessary to eliminate adhesion loss due to strains in large sheets of PZT, and to eliminate excessive parasitic capacitances due to the high dielectric constant of PZT. At this point in the process, the PZT is in a confined area and the bottom electrode layer 18 is now partially exposed. Next, photoresist 26 is removed to yield the structure shown in Fig. 7.

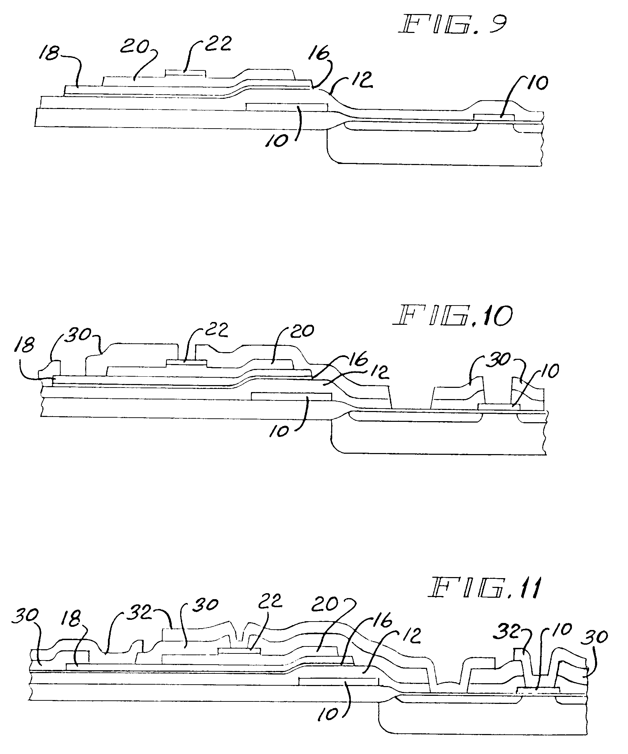

After the exposed PZT has been removed, another photoresist pattern 28 is made by conventional means which defines the area of the bottom electrode layer 18 shown in Fig. 8, so that succeeding metallization steps can contact the capacitor bottom electrode. The bottom electrode structure (adhesion layer 16 and layer 18) is then patterned by ion milling, plasma etching or wet etching to leave only the desired contact areas as shown in Figure 9.

Finally, the capacitor structure is isolated by deposition, of a layer 30 of doped or undoped $SiO_2$ which is patterned by opening contact windows to transistor source/drain areas, transistor gates as well as ferroelectric top and bottom source electrode areas as shown in Fig. 10. The device is completed by depositing an aluminum layer 32 and defining the aluminum to form interconnects between devices. The completed device is shown in Figure 11.

## Claims

1. A method for forming a high-quality planar ferroelectric capacitor comprising the steps of forming a bottom electrode structure (16, 18) characterized by depositing a layer of Pb-$(Zr_xTi_{1-x})O_3$ (20) over said bottom electrode wherein x is from 0.0 to .92, annealing at a temperature above 500°C in an $O_2$ ambient, establishing a top electrode layer (22) of noble metal or noble metal alloy over said layer of $Pb(Zr_xTi_{1-x})O_3$, depositing a first photoresist pattern (24) over said top electrode layer to define the area of a capacitor, removing the noble metal top electrode layer not covered by the photoresist pattern, removing the photoresist pattern, annealing at a temperature above 500°C in an $O_2$ ambient, depositing a second photoresist pattern (26) over an area larger than that of the previously defined capacitor, removing the exposed $Pb(Zr_xTi_{1-x})O_3$ layer (20), removing the second photoresist layer (26), depositing a third photoresist pattern (28) over an area larger than the previously defined $Pb(Zr_xTi_{1-x})O_3$ pattern, removing the exposed bottom electrode (16, 18), removing the third photoresist layer (28), isolating the completed capacitor structure by establishing a layer (30) of doped or undoped $SiO_2$, opening contacts to the transistor source/drain areas as well as to the top and bottom electrodes of the ferroelectric capacitor, and depositing a conductive layer (32) to form an interconnect between said source/drain areas and said ferroelectric capacitor.

2. The method of Claim 1 wherein said bottom electrode comprises a first metal (18) and titanium (16).

3. The method of Claim 2, wherein said first metal (18) comprises platinum.

4. The method of Claim 2 wherein said first metal (18) comprises palladium.

5. The method of Claim 2 wherein said first metal (18) comprises an alloy of at least two metals selected from the group of platinum, palladium, titanium, rhenium, bismuth and ruthenium.

6. The method of Claim 1 wherein said top electrode noble metal (22) comprises platinum.

7. The method of Claim 1 wherein said top electrode noble metal (22) alloy comprises at least two metals selected from the group of platinum, palladium, titanium, rhenium, bismuth and ruthenium.

8. The method of Claim 1 wherein said layer of $Pb(Zr_xTi_{1-x})O_3$ (20) has a thickness from 500 Angstroms to 1.0 microns.

9. In an integrated circuit memory device, a planar capacitor storage element characterized by having a bottom electrode (16, 18) comprising a noble metal or noble metal alloy, a ferroelectric film (20) overlying said bottom electrode, said ferroelectric film having a thickness from 500 Angstroms to 1.0 microns, and a top electrode (22) comprising a noble metal or noble metal alloy overlying said ferroelectric film.

10. The storage element of Claim 9 wherein said ferroelectric film (20) is lead zirconate titanate.

11. The storage element of Claim 10 wherein said lead zirconate titanate (20) composition is defined by the chemical formula $Pb(Zr_xTi_{1-x})O_3$ wherein x is from 0.0 to .92.

12. The storage element of Claim 9 wherein said bottom electrode (16, 18) is comprised of a first metal layer (18) overlying a layer of titanium, said first metal layer (16) having a thickness of 500 to 5000 Angstroms, and said titanium layer having a thickness of 100 to 1500 Angstroms.

13. The storage element of Claim 12 wherein the first metal (18) is palladium.

14. The storage element of Claim 12 wherein the first metal (18) is platinum.

15. The storage element of Claim 12 wherein said first metal (18) comprises an alloy of any two elements from the group consisting of: platinum, palladium, titanium, bismuth, ruthenium and rhenium.

16. The storage element of Claim 12 wherein said first metal (18) is an alloy of platinum, bismuth and titanium.

17. The storage element of Claim 12 wherein said first metal (18) comprises an alloy of palladium, bismuth and titanium.

18. The storage element of Claim 12 wherein said first metal (18) comprises an alloy of platinum, palladium and titanium.

19. The storage element of Claim 9 wherein said top electrode (22) thickness is from 100 to 5000 Angstroms.

20. The storage element of Claim 9 wherein said top electrode (22) comprises platinum.

21. The storage element of Claim 9 wherein said top electrode (22) comprises palladium.

22. The storage element of Claim 9 wherein said top electrode (22) comprises an alloy of at least two of the following: platinum, palladium, titanium, bismuth, ruthenium and rhenium.

23. The storage element of Claim 9 wherein said top electrode (22) is comprised of an alloy of platinum, palladium and titanium.

24. The storage element of Claim 9 wherein said top electrode (22) is comprised of an alloy of platinum, bismuth and titanium.

25. The storage element of Claim 9 wherein said top electrode (22) is comprised of an alloy of palladium, bismuth and titanium.

26. The storage element of Claim 9 wherein said top electrode (22) is comprised of an alloy of ruthenium and either platinum or palladium.

27. In a memory device, a planar capacitor storage element characterized by having a patterned metal interconnect overlying a dielectric isolation layer, said metal interconnect contacting a patterned noble metal or noble metal alloy top electrode (22) through an opening etched in said dielectric layer, said patterned top electrode overlying a patterned ferroelectric film (20) which extends outside the edges of said patterned top electrode, said ferroelectric film overlying a patterned noble metal or noble metal alloy bottom electrode 16, 18).

28. The planar capacitor storage element of Claim 27 wherein said bottom electrode (16, 18) is comprised of a first metal (18) overlying a layer of titanium (16).

29. The planar capacitor storage element of Claim 28 wherein said first metal (18) comprises an alloy of at least two metals selected from the group of platinum, palladium, titanium, bismuth, rhenium, ruthenium.

*FIG. 1*

12    10    10

*FIG. 2*

20  18  16    10

12   10

*FIG. 3*

18  22  24  20  12    10    10

16

*FIG. 4.*

18  22  20  16    10    10

12

FIG. 5

FIG. 6

FIG. 7

FIG. 8

FIG. 9

FIG.10

FIG.11